(19) Europäisches Patentamt
European Patent Office
Office européen des brevets

(11) **EP 2 541 615 B1**

(12) **EUROPEAN PATENT SPECIFICATION**

(45) Date of publication and mention
of the grant of the patent:
**06.05.2020 Bulletin 2020/19**

(51) Int Cl.:
***H01L 31/04*** *(2014.01)*    ***H01L 31/068*** *(2012.01)*
***H01L 31/0216*** *(2014.01)*

(21) Application number: **11747377.7**

(22) Date of filing: **23.02.2011**

(86) International application number:
**PCT/JP2011/053951**

(87) International publication number:
**WO 2011/105417 (01.09.2011 Gazette 2011/35)**

(54) **SOLAR CELL**

SOLARZELLE

CELLULE SOLAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.02.2010 JP 2010037971**

(43) Date of publication of application:
**02.01.2013 Bulletin 2013/01**

(73) Proprietor: **Panasonic Intellectual Property
Management Co., Ltd.
Osaka-shi, Osaka 540-6207 (JP)**

(72) Inventor: **BABA Hideaki
Moriguchi-shi
Osaka 570-8677 (JP)**

(74) Representative: **Mewburn Ellis LLP
Aurora Building
Counterslip
Bristol BS1 6BX (GB)**

(56) References cited:
**JP-A- 9 055 521      JP-A- 9 246 578
JP-A- 2007 227 692    US-A1- 2009 283 145**

• **FERRE R ET AL: "n-type emitter surface
passivation in c-Si solar cells by means of
antireflective amorphous silicon carbide layers",
JOURNAL OF APPLIED PHYSICS, AMERICAN
INSTITUTE OF PHYSICS, US, vol. 100, no. 7, 5
October 2006 (2006-10-05), pages 73703-073703,
XP012090165, ISSN: 0021-8979, DOI:
10.1063/1.2354323**

**Description**

TECHNICAL FIELD

The invention relates to a solar cell using crystalline silicon, and more specifically to a solar cell which achieves an increased open circuit voltage.

BACKGROUND ART

Conventionally, for a solar cell using crystalline silicon (hereinafter abbreviated as crystalline Si as appropriate), a large number of attempts have been made to increase open circuit voltage under light irradiation (hereinafter abbreviated as open circuit voltage as appropriate) by suppressing recombination of carriers on the crystalline Si as much as possible.

For example, in a solar cell described in non-patent document 1, high-quality single crystalline Si is used to suppress recombination of carriers inside a semiconductor. In addition, in order to suppress recombination of carries on the surface of the semiconductor, the surface is almost entirely covered with a silicon oxide film and is provided with a diffusion region at a portion in contact with metal.

According to non-patent document 1, an open circuit voltage of approximately 0.7 V is obtained in the solar cell having the above-described structure.

US 2009/283145 A1 discloses a solar cell with a substrate having a light collecting surface thereon and a P-N rectifying junction within the substrate. The P-N rectifying junction includes a base region of first conductivity type (e.g., p-type) and a semiconductor layer of second conductivity type extending between the base region and the light collecting surface. A trench is also provided, which extends through the semiconductor layer and into the base region. First and second electrodes are provided adjacent the light collecting surface. The first electrode is electrically coupled to the semiconductor layer and the second electrode is electrically coupled to the base region, at a location adjacent a bottom of the trench.

"n-type emitter surface passivation in c-Si solar cells by means of antireflective amorphous silicon carbide layers", C. Ferre et al., Journal of Applied Physics, vol. 100, no. 7, 5 October 2006, is a research article describing stacks of two $SiC_x$ layers that were deposited by plasma enhanced chemical vapor deposition: first a thin silicon rich layer with passivating properties and then an antireflective carbon rich layer. The thickness of the passivating layer was optimized, reaching a trade-off between the better passivation achieved for thicker layers and the increased light absorption within the layer, which reduced the photocurrent.

PRIOR ART DOCUMENT

NON-PATENT DOCUMENT

Non-patent Document 1: A. Wang et al. "24% efficient silicon solar cells", Applied Physics Letter Vol. 57, p602, 1990

SUMMARY OF THE INVENTION

PROBLEM TO BE SOLVED BY THE INVENTION

As for the solar cell having the above-described structure, in the crystalline Si under the condition in which an external circuit connected to a front electrode and a rear electrode is open, the quasi Fermi level of electrons is equal to the Fermi level of the negative electrode, and the quasi Fermi level of holes is equal to the Fermi level of the positive electrode. In other words, the open circuit voltage is equal to the difference between the quasi Fermi level of electrons and the quasi Fermi level of holes in the crystalline Si.

Accordingly, a generally-considered method of increasing the open circuit voltage is to increase the difference between the quasi Fermi level of electrons and the quasi Fermi level of holes by suppressing recombination on crystalline Si as much as possible.

The invention has been made in view of such circumstances, and an object thereof is to provide a solar cell achieving an increased open circuit voltage without relying on suppression of recombination on crystalline Si.

MEANS FOR SOLVING THE PROBLEM

A solar cell according to an aspect of the invention is set out in claim 1.

EFFECTS OF THE INVENTION

According to the aspect of the invention, a solar cell can be provided which achieves an increased open circuit voltage without relying on suppression of recombination in crystalline Si.

BRIEF DESCRIPTION OF THE DRAWINGS

[Fig. 1] Fig. 1 is a view schematically showing a structure of solar cell 10 according to an embodiment of the invention.
[Fig. 2] Fig. 2 is a view showing depth dependencies of various kinds of energy in a conventional solar cell using crystalline.
[Fig. 3] Fig. 3 is a view showing depth dependencies of various kinds of energy in solar cell 10 according to the embodiment of the invention.
[Fig. 4] Fig. 4 is a view schematically showing a structure of solar cell 10A according **to example 1, which is not part of the invention.**
[Fig. 5] Fig. 5 is a view schematically showing a structure of solar cell 10B according to example 2, which is part of the invention.
[Fig. 6] Fig. 6 is a view showing values of $\Delta V$ obtained from open circuit voltage Va and the difference between the quasi Fermi level of electrons and the quasi Fermi level of holes in crystalline Si, in solar cell 10B according to example 2.

MODES FOR CARRYING OUT THE INVENTION

Next, embodiments of a solar cell according to the invention are described with reference to the drawings. Note that the drawings are schematic and ratios of dimensions and the like are different from actual ones. Moreover, it should be noted that, in the following description of the drawings, same or similar reference signs denote same or similar elements and portions, and the description thereof is omitted as appropriate.
Hence, specific dimensions and the like should be determined in consideration of the following description. Moreover, the drawings may also include portions having different dimensional relationships and ratios from each other.

(1) Structure of Solar Cell

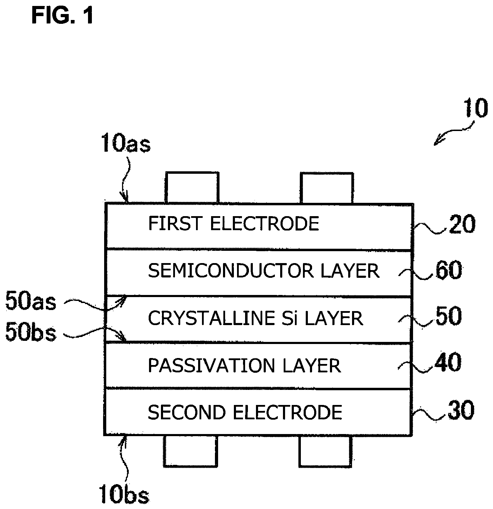

Fig. 1 schematically shows the structure of solar cell 10 according to the embodiment. Solar cell 10 is solar cell 10 using crystalline Si including a pn junction formed therein. As shown in Fig. 1, solar cell 10 includes first electrode 20, second electrode 30, passivation layer 40, crystalline Si layer 50, and thin-film semiconductor layer 60. In solar cell 10, second electrode 30, passivation layer 40, crystalline Si layer 50, semiconductor layer 60, and first electrode 20 are stacked in this order from second main surface lObs toward first main surface 10as.
A light incident side of solar cell 10 is set at either one of electrode sides where first electrode 20 is provided on a first main surface 10as side and where second electrode 30 is provided on second main surface lObs. The electrode placed on the light incident side is formed to be light transmissive so that the largest possible amount of light can enter crystalline Si layer 50.
First electrode 20 and second electrode 30 are formed of a metal such as silver (AG) or copper (Cu). One electrode out of first electrode 20 and second electrode 30, which is placed on the light incident side, is formed in such a light transmissive shape like a comb shape that incident light can transmit to crystalline Si layer 50. Meanwhile, the shape of the other electrode is not especially limited. The other electrode may be in a light transmissive shape like the one electrode, or may be formed to exert a light blocking effect such as to almost entirely cover second main surface lObs of crystalline Si layer 50.
In addition, first electrode 20 and second electrode 30 may have a translucent conductive film formed of a translucent conductive oxide such as an indium oxide or zinc oxide on a crystalline Si layer 50 side.
Passivation layer 40 has a property of suppressing recombination of carriers on the surface of crystalline Si layer 50. Passivation layer 40 is formed on second main surface 50bs of the crystalline silicon layer, which is on the opposite side of crystalline Si layer 50 from first main surface 50as. Passivation layer 40 may be formed of an amorphous semiconductor containing hydrogen (a-Si:H, a-SiC:H, or the like), as described below.
Crystalline Si layer 50 is a layer in which a pn junction is formed. Single crystalline silicon or polycrystalline silicon is used for crystalline Si layer 50.
Semiconductor layer 60 is formed on first main surface 50as of crystalline Si layer 50. Semiconductor layer 60 is formed of

a-Si:H. Semiconductor layer 60 has the same conductivity type as a portion of crystalline Si layer 50 in contact with semiconductor layer 60. In addition, semiconductor layer 60 contains a dopant of the same conductivity type as a portion of crystalline Si layer 50 in contact with semiconductor layer 60. Note that the dopant concentration of semiconductor layer 60 in the vicinity of the interface of semiconductor layer 60 with crystalline Si layer 50 is $1 \times 10^{19}$/cc or higher. Here, the vicinity of the interface refers to a region within 5 nm from the interface.

(2) Properties of Solar Cell

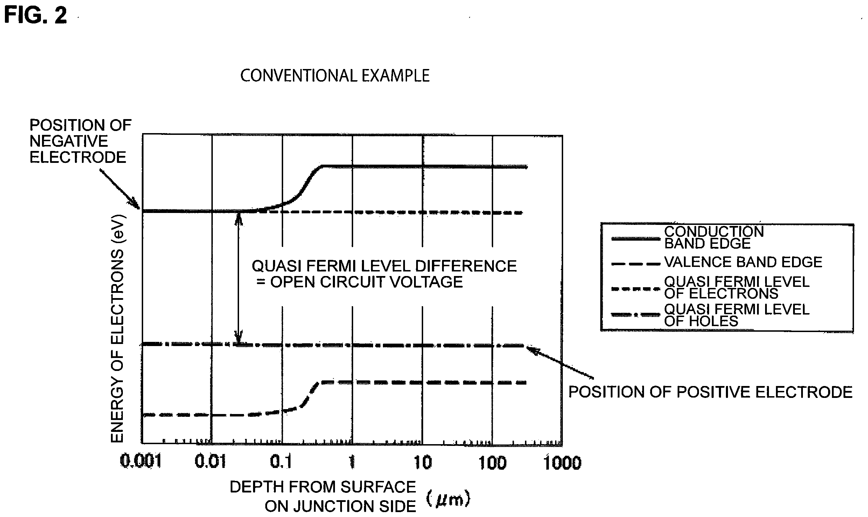

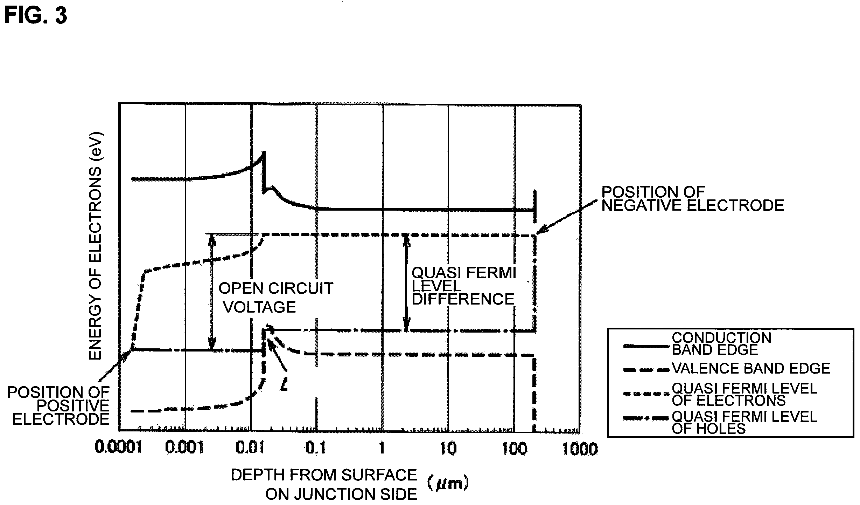

Next, properties of solar cell 10 mentioned above are described with reference to Figs. 2 and 3. Fig. 2 shows depth dependency of various kinds of energy in a conventional solar cell using crystalline Si. Fig. 3 shows depth dependency of various kinds of energy in solar cell 10.

As for the conventional solar cell described in the non-patent document 1 or the like, in the crystalline Si under the condition in which an external circuit connected to a front electrode and a rear electrode is open, the quasi Fermi level of electrons is equal to the Fermi level of the negative electrode, and the quasi Fermi level of holes is equal to the Fermi level of the positive electrode, as shown in Fig. 2. In other words, the open circuit voltage is equal to the difference between the quasi Fermi level of electrons and the quasi Fermi level of holes in crystalline Si.

In contrast, as for solar cell 10, when solar cell 10 is irradiated with light and an external circuit (not shown) connected to first electrode 20 and second electrode 30 is open, open circuit voltage Va of solar cell 10 is not equal to difference Vb between the quasi Fermi level of electrons and the quasi Fermi level of holes in the crystalline Si (hereinafter referred to as quasi Fermi level difference Vb).

Specifically, as shown in Fig. 3, **in a non-claimed case where** semiconductor layer 60 is formed of a-SiC:H, the quasi Fermi level of holes in crystalline Si layer 50 is different by ΔV from the quasi Fermi level of the positive electrode under light irradiation in the open state. Here, the Fermi level of the positive electrode is equal to the quasi Fermi level of holes in semiconductor layer 60. Moreover, the Fermi level of the negative electrode is equal to the quasi Fermi level of electrons in crystalline Si layer 50. Accordingly, the open circuit voltage can be expressed as shown in (equation 1).

$$\texttt{Open circuit voltage Va = quasi Fermi level difference}$$
$$\texttt{Vb + ΔV … (equation 1)}$$

To put it differently, open circuit voltage Va is different from the quasi Fermi level difference Vb in crystalline Si layer 50 by ΔV. If ΔV is a positive value, that is, if the value obtained by subtracting quasi Fermi level difference Vb from open circuit voltage Va is a positive value, open circuit voltage Va increases by ΔV from quasi Fermi level difference Vb in the crystalline Si.

It should be noted that an electric field in semiconductor layer 60 does not always complement the electric field of the pn homojunction in crystalline Si layer 50 to increase open circuit voltage Va. In the case where the Fermi level in semiconductor layer 60 before contact with crystalline Si layer 50 is higher than the Fermi level in crystalline Si layer 50, electrons in semiconductor layer 60 move to crystalline Si layer 50 through the contact between crystalline Si layer 50 and semiconductor layer 60. Hence, the electric field formed in semiconductor layer 60 has an opposite direction from the electric field formed by the pn junction in crystalline Si layer 50 (refer to Fig. 3).

(3) Examples

Next, examples of solar cell 10 mentioned above are described. Specifically, examples 1 and 2 of solar cell 10 are described.

(3. 1) Example 1, **which is not part of the invention.**

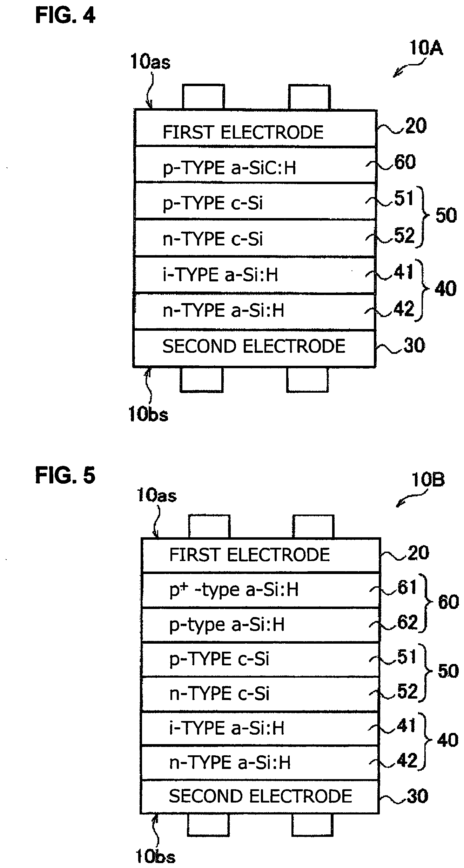

Fig. 4 schematically shows the structure of solar cell 10A according to example 1. Hereinafter, description is given on the structure, manufacturing steps, device properties, and measuring method of quasi Fermi level difference of solar cell 10A.

(3. 1. 1) Structure of Solar Cell 10A

As shown in Fig. 4, passivation layer 40 of solar cell 10A includes amorphous semiconductors, or to be more specific, i-type a-Si:H layer 41 and n-type a-Si:H layer 42. Crystalline Si layer 50 of solar cell 10A includes single crystalline Si, or to be more specific, p-type c-Si layer 51 and n-type c-Si layer 52.

In solar cell 10A, n-type c-Si layer 52 and n-type a-Si:H layer 42 form an electrical field to suppress recombination of minority carriers. In addition, thin (approximately 1 nm to 10 nm) i-type a-Si:H layer 41 improves the properties between n-type c-Si layer 52 and n-type a-Si:H layer 42.

(3. 1. 2) Manufacturing Method of Solar Cell 10A

Step 1) First, anisotropic etching is performed on an n-type single crystalline Si wafer (n-type c-Si layer 52) using an alkali aqueous solution to form fine irregularities on a wafer surface. After that, the wafer is washed as usual to remove impurities on the wafer surface.

Step 2) By the PECVD method using a mixed gas of $B_2H_6$, $H_2$, and $SiH_4$, thin p-type c-Si layer 51 is epitaxially grown on one surface of the wafer to form a homojunction. The thickness of p-type c-Si layer 51 is set to 5 nm, and the amount of boron (B) doped is set to $1\times10^{20}$/cc. Note that the amount of B doped may be $1\times10^{19}$/cc to $1\times10^{21}$/cc. Moreover, the epitaxial growth can be made by thermal CVD, photo CVD, MBE, or sputtering. In the case where p-type c-Si is formed at low temperature, p-type c-Si may be heated to remove hydrogen in p-type c-Si.

Step 3) By the PECVD method using a mixed gas of $B_2H_6$, $H_2$, $CH_4$, and $SiH_4$, p-type a-SiC:H having a thickness of 10 nm is deposited as semiconductor layer 60 on p-type c-Si layer 51. Note that the range of deposition of p-type a-SiC:H may be 5 nm to 20 nm. The amount of B doped is set to $1\times10^{19}$/cc. Note that the amount of B doped may be $1\times10^{18}$/cc to $1\times10^{21}$/cc. The temperature for forming p-type a-SiC:H is set to 200°C. Note that the temperature may be 100°C to 300°C.

Step 4) By the PECVD method using a mixed gas of $PH_3$, $H_2$, and $SiH_4$, i-type a-Si:H layer 41 and n-type a-Si:H layer 42 each having a thickness of 5 nm are deposited in that order as passivation layer 40 on an opposite surface of n-type c-Si layer 52 from the junction.

Step 5) By sputtering, tin(Sn)-doped indium oxide thin films each having a thickness of 100 nm are formed as first electrode 20 and second electrode 30 on first main surface 10as and second main surface lObs (see Fig. 1). Further, thermosetting AG paste is screen-printed on both surfaces of the ITO, and then cured by heating. Thus, collector electrodes are formed.

(3. 1. 3) Device Properties

Open circuit voltage Va of solar cell 10A made by the above-described manufacturing method is measured under the irradiation of 1 sun by a solar simulator (spectrum AM 1.5 G, intensity 0.1 W/cm$^2$). Open circuit voltage Va is 0.701 V.

In addition to solar cell 10A having open circuit voltage Va measured, a sample is simultaneously prepared in the steps up to the formation of transparent conductive films (ITO) . The sample is heated in the same condition as the heat curing without collector electrodes screen-printed thereon. Then, quasi Fermi level difference Vb in crystalline Si of the sample is evaluated using measuring device WCT-100 manufactured by Sinton Consulting, Inc. described below. Note that the reason for this heat treatment is that the properties of a hetero junction between a-Si:H and crystalline Si may change depending on heat history after the formation of a-Si:H. Further, after open circuit voltage Va is evaluated, the collector electrodes may be removed by etching or the like, and then quasi Fermi level difference Vb may be evaluated. In this case, it is found that even the removal of the transparent conductive films (ITO) does not affect the measurement result (value of quasi Fermi level difference Vb).

Since WCT-100 evaluates a region in a circular coil, multiple places on the cell surface are measured to confirm that there is almost no in-plane distribution of the value of quasi Fermi level difference Vb. Evaluated quasi Fermi level difference Vb in crystalline Si layer 50 (under irradiation of 1 sun) is 0.674 V, which is 27 mV lower than open circuit voltage Va.

The same measurement is performed on a sample prepared in the above manufacturing method in which a homojunction is formed with the above-described step 3) excluded and an ohmic electrode of Al or the like is formed directly on p+-type c-Si in place of step 5). As a result, open circuit voltage Va is equal to quasi Fermi level difference Vb. This tells that passivation layer 40 and crystalline Si layer 50 have no gap in the quasi Fermi level of electrons. Instead, this evaluation may be performed on a sample prepared by removing passivation layer 40 and directly forming an ohmic electrode in order to make the Fermi level in the negative electrode continuous with the Fermi level of electrons in crystalline Si layer 50.

As described above, using the negative electrode as a reference, the positive electrode has 0.701 V and crystalline Si layer 50 has 0.674 V. Thus, it is confirmed that quasi Fermi level of holes is different by 27 mV between crystalline Si layer 50 and semiconductor layer 60.

(3. 1. 4) Measuring Method of Quasi Fermi Level Difference

The above-described measurement of quasi Fermi level difference Vb uses measuring device WCT-100 Silicon Wafer Lifetime Tester manufactured by Sinton Consulting, Inc (currently Sinton Instruments). A measuring method used in WCT-100 is called QSSPC (Quasi Steady State Photo Conductance) method. In this method, measurement is generally performed as follows.

A circular coil with a diameter of approximately 2cm to measure electric conductivity of a crystalline Si wafer in a non-contact state and a photodetector to measure intensity of irradiation light (irradiation intensity) are provided on a sample stage. First, a measurement part of the crystalline Si wafer is placed on the circular coil.

Next, the crystalline Si wafer is irradiated with flash light to measure a change of the electric conductivity over time. At the same time, a change of the irradiation intensity over time is measured by the photodetector. By analyzing these data, the dependency of quasi Fermi level difference Vb in the crystalline Si wafer on the irradiation intensity can be obtained.

(3. 2) Example 2, **which is part of the invention.**

Fig. 5 schematically shows the structure of solar cell 10B according to example 2. Hereinafter, description is given on the structure, manufacturing steps, and device properties of solar cell 10B.

(3. 2. 1) Structure of Solar Cell 10B

As shown in Fig. 5, solar cell 10B is different from solar cell 10A in the structure of semiconductor layer 60. Specifically, semiconductor layer 60 according to this embodiment includes p+-type a-Si:H layer 61 and p-type a-Si:H layer 62.

(3. 2. 2) Manufacturing Method of Solar Cell 10B

A manufacturing method of solar cell 10B is the same as that of solar cell 10A except for step 3). In step 3) for solar cell 10B, by the PECVD method using a mixed gas of $B_2H_6$, $H_2$, and $SiH_4$, p-type a-Si:H layer 62 and p+-type a-Si:H layer 61 each having a thickness of 5 nm are deposited as semiconductor layer 60 on p-type c-Si layer 51. Note that the dopant concentration of p+-type a-Si:H layer 61 is set to $1\times10^{21}$/cc, and the dopant concentration of p-type a-Si:H layer 62 is varied **from $1\times10^{19}$/cc to** $1\times10^{21}$/cc. In addition, the temperature for forming semiconductor layer 60 is set to 200°C. Here, the temperature may be 100°C to 300°C.

(3. 2. 3) Device Property

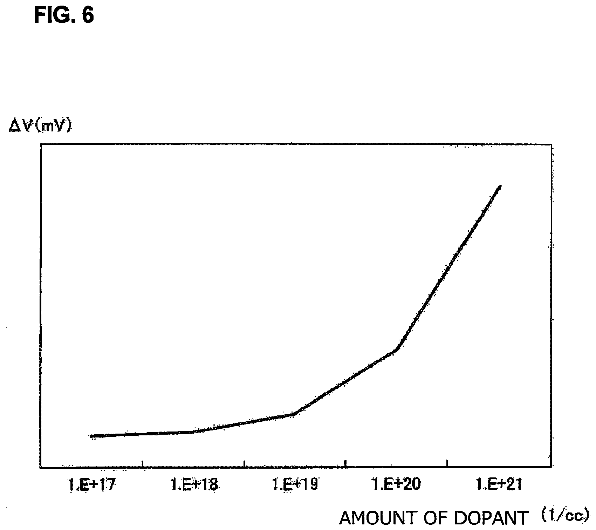

As is the case in solar cell 10A, open circuit voltage Va and quasi Fermi level difference Vb in crystalline Si are measured. Fig.6 shows values of $\Delta V$ (=Va-Vb) obtained from measured open circuit voltage Va and quasi Fermi level difference Vb. As shown in Fig. 6, it is found that when the dopant concentration is more than the order of $1\times10^{19}$/cc, the effect of doping is significant and $\Delta V$ becomes higher.

In other words, in the case where semiconductor layer 60 is amorphous semiconductor, open circuit voltage Va can be effectively increased by setting the dopant concentration of semiconductor layer 60 in the vicinity of the interface with crystalline Si layer 50 to be $1\times10^{19}$/cc or higher.

(4) Other Embodiments

As described above, the invention has been disclosed by using the embodiments of the invention. However, it should not be understood that the description and drawings which constitute part of this disclosure limit the invention. From this disclosure, various alternative embodiments, examples, and operation techniques will be easily found by those skilled in the art.

The conductivity type of semiconductor layer 60 may be p-type or n-type. Note that the conductivity type of crystalline Si layer 50 is opposite from the conductivity type of semiconductor layer 60.

The invention can be also applied to a thin-film solar cell including crystalline Si layer formed on a substrate by epitaxial growth.

As described above, the invention naturally includes various embodiments which are not described herein. Accordingly, a technical scope of the invention should be determined only by the subject matters in claims regarded as appropriate based on the description.

EXPLANATION OF THE REFERENCE NUMERALS

| 10, 10A, 10B | solar cell 10A |
| 10as | first main surface |
| lObs | second main surface |
| 20 | first electrode |
| 30 | second electrode |
| 40 | passivation layer |
| 41 | i-type a-Si:H layer |
| 42 | n-type a-Si:H layer |
| 50 | crystalline Si layer |
| 50as | first main surface |
| 50bs | second main surface |
| 51 | p-type c-Si layer |
| 52 | n-type c-Si layer |
| 60, 60A | semiconductor thin-film layer |
| 61 | p+-type a-Si:H layer |
| 62 | p-type a-Si:H layer |

**Claims**

1. A solar cell (10B) comprising:

a crystalline silicon layer (50) including a pn junction, the crystalline silicon layer (50) including a first crystalline silicon layer (51) of a first conductivity type and a second crystalline silicon layer (52) of a second conductivity type formed on the first crystalline silicon layer (51) to form the pn junction;
an amorphous semiconductor layer (60) formed on the first crystalline silicon layer (51), the amorphous semiconductor layer (60) being made of hydrogenated amorphous silicon, a-Si:H; and
a passivation layer (40) formed on the second crystalline silicon layer (52); wherein
the amorphous semiconductor layer (60) contains a dopant of the same conductivity type as the first crystalline silicon layer (51);
**characterized in that**:

the amorphous semiconductor layer (60) includes a first sublayer (61) and a second sublayer (62), the second sublayer (62) being formed on the first crystalline silicon layer (51), and the first sublayer (61) being formed on the second sublayer (62), wherein the first sublayer (61) and the second sublayer (62) each have a thickness of 5nm; and
the dopant concentration of the first sublayer (61) of the amorphous semiconductor layer (60) is $1 \times 10^{21}$/cc and the dopant concentration of the second sublayer (62) of the amorphous semiconductor layer (60) is between $1 \times 10^{19}$/cc and $1 \times 10^{21}$/cc.

2. The solar cell (10B) according to claim 1, wherein the passivation layer (40) is formed of an amorphous semiconductor containing hydrogen.

3. The solar cell (10B) according to claim 1, further comprising:

a first electrode (20) formed on the amorphous semiconductor layer (60) such that it is on a first main surface (10as) side of the solar cell (10B); and
a second electrode (30) formed on the passivation layer (40) such that it is on a second main surface (lObs) side of the solar cell (10B); wherein
the first electrode (20) and the second electrode (30) are each formed of a metal deposited on a translucent conductive film formed of a translucent conductive oxide; and
the metal of the first electrode (20) is formed in a light transmissive shape.

**Patentansprüche**

1. Solarzelle (10B), die Folgendes umfasst:

eine kristalline Siliciumschicht (50), einschließlich eines p-n-Übergangs, wobei die kristalline Siliciumschicht (50) eine erste kristalline Siliciumschicht (51) eines ersten Leitfähigkeitstyps und eine zweite kristalline Siliciumschicht (52) eines zweiten Leitfähigkeitstyps, die auf der ersten kristallinen Siliciumschicht (51) ausgebildet ist, um den p-n-Übergang auszubilden, umfasst;
eine amorphe Halbleiterschicht (60), die auf der ersten kristallinen Siliciumschicht (51) ausgebildet ist, wobei die amorphe Halbleiterschicht (60) aus hydriertem amorphem Silicium a-Si:H besteht; und
eine Passivierungsschicht (40), die auf der zweiten kristallinen Siliciumschicht (52) ausgebildet ist; wobei die amorphe Halbleiterschicht (60) ein Dotierungsmittel desselben Leitfähigkeitstyps wie die erste kristalline Siliciumschicht (51) umfasst;
**dadurch gekennzeichnet, dass**:

die amorphe Halbleiterschicht (60) eine erste Unterschicht (61) und eine zweite Unterschicht (62) umfasst, wobei die zweite Unterschicht (62) auf der ersten kristallinen Siliciumschicht (51) ausgebildet ist und die erste Unterschicht (61) auf der zweiten Unterschicht (62) ausgebildet ist, wobei die erste Unterschicht (61) und die zweite Unterschicht (62) jeweils eine Dicke von 5 nm aufweisen; und
die Dotierungsmittelkonzentration der ersten Unterschicht (61) der amorphen Halbleiterschicht (60) 1 x $10^{21}$/cc beträgt und die Dotierungsmittelkonzentration der zweiten Unterschicht (62) der amorphen Halbleiterschicht (60) zwischen 1 x $10^{19}$/cc und 1 x $10^{21}$/cc liegt.

2. Solarzelle (10B) nach Anspruch 1, wobei die Passivierungsschicht (40) aus einem wasserstoffhältigen amorphen Halbleiter ausgebildet ist.

3. Solarzelle (10B) nach Anspruch 1, die außerdem Folgendes umfasst:

eine erste Elektrode (20), die so auf der amorphen Halbleiterschicht (60) ausgebildet ist, dass sie auf der Seite einer ersten Hauptfläche (10as) der Solarzelle (10B) angeordnet ist; und
eine zweite Elektrode (30), die so auf der Passivierungsschicht (40) ausgebildet ist, dass sie auf der Seite einer zweiten Hauptfläche (10bs) der Solarzelle (10B) angeordnet ist; wobei
die erste Elektrode (20) und die zweite Elektrode (30) jeweils aus einem Metall bestehen, das auf einem durchscheinenden leitfähigen Film, der aus einem transluzenten leitfähigen Oxid ausgebildet ist, abgeschieden wurde; und
das Metall der ersten Elektrode (20) in einer lichtdurchlässigen Form ausgebildet ist.

**Revendications**

1. Cellule solaire (10B) comprenant :

une couche de silicium cristallin (50) comprenant une jonction pn, la couche de silicium cristallin (50) comprenant une première couche de silicium cristallin (51) d'un premier type de conductivité et un seconde couche de silicium cristallin (52) d'un second type de conductivité formée sur la première couche de silicium cristallin (51) afin de former la jonction pn ;
une couche de semi-conducteur amorphe (60) formée sur la première couche de silicium cristallin (51), la couche de semi-conducteur amorphe (60) étant composée de silicium amorphe hydrogéné, a-Si:H ; et
une couche de passivation (40) formée sur la seconde couche de silicium cristallin (52) ; dans laquelle
la couche de semi-conducteur amorphe (60) contient un dopant du même type de conductivité que la première couche de silicium cristallin (51) ;
**caractérisée en ce que** :

la couche de semi-conducteur amorphe (60) comprend une première sous-couche (61) et une seconde sous-couche (62), la seconde sous-couche (62) étant formée sur la première couche de silicium cristallin (51), et la première sous-couche (61) étant formée sur la seconde sous-couche (62), dans laquelle la première sous-couche (61) et la seconde sous-couche (62) possèdent chacune une épaisseur de 5 nm ; et
la concentration en dopant de la première sous-couche (61) de la couche de semi-conducteur amorphe

(60) est de $1\times10^{21}$/cc, et la concentration en dopant de la seconde sous-couche (62) de la couche de semi-conducteur amorphe (60) est comprise entre $1\times10^{19}$/cc et $1\times10^{21}$/cc.

2. Cellule solaire (10B) selon la revendication 1, dans laquelle la couche de passivation (40) est formée d'un semi-conducteur amorphe contenant de l'hydrogène.

3. Cellule solaire (10B) selon la revendication 1, comprenant en outre :

une première électrode (20) formée sur la couche de semi-conducteur amorphe (60) de sorte qu'elle se trouve côté première surface principale (10as) de la cellule solaire (10B) ; et
une seconde électrode (30) formée sur la couche de passivation (40) de sorte qu'elle se trouve côté seconde surface principale (10bs) de la cellule solaire (10B) ; dans laquelle
la première électrode (20) et la seconde électrode (30) sont chacune formées d'un métal déposé sur un film conducteur translucide formé d'un oxyde conducteur translucide ; et
le métal de la première électrode (20) est formé de façon à transmettre la lumière.

**FIG. 1**

## FIG. 2

CONVENTIONAL EXAMPLE

**FIG. 3**

## FIG. 4

10as

10A

| FIRST ELECTRODE | 20 |
| p-TYPE a-SiC:H | 60 |
| p-TYPE c-Si | 51 } 50 |
| n-TYPE c-Si | 52 |
| i-TYPE a-Si:H | 41 } 40 |
| n-TYPE a-Si:H | 42 |
| SECOND ELECTRODE | 30 |

10bs

## FIG. 5

10as

10B

| FIRST ELECTRODE | 20 |
| p$^+$-type a-Si:H | 61 } 60 |
| p-type a-Si:H | 62 |
| p-TYPE c-Si | 51 } 50 |
| n-TYPE c-Si | 52 |
| i-TYPE a-Si:H | 41 } 40 |
| n-TYPE a-Si:H | 42 |
| SECOND ELECTRODE | 30 |

10bs

FIG. 6

## REFERENCES CITED IN THE DESCRIPTION

**Patent documents cited in the description**

- US 2009283145 A1

**Non-patent literature cited in the description**

- **C. FERRE et al.** n-type emitter surface passivation in c-Si solar cells by means of antireflective amorphous silicon carbide layers. *Journal of Applied Physics,* 05 October 2006, vol. 100 (7

- **A. WANG et al.** 24% efficient silicon solar cells. *Applied Physics Letter,* 1990, vol. 57, 602